# EUROPEAN PATENT APPLICATION

(11) **EP 2 755 350 A1**
(43) Date of publication of application: **16.07.2014**
(21) Application number: 13290008.5
(22) Date of filing: 15.01.2013
(51) Int. Cl.: H04L 7/033, H03L 7/081, H04J 3/04

(54) **Apparatus for performing clock and/or data recovery**

(71) Applicant: Alcatel Lucent, 75007 Paris (FR)
(72) Inventor: Pöhlmann, Wolfgang, 71282 Hemmingen (DE); Suikat, Detlef, 75395 Ostelsheim (DE)
(74) Representative: DREISS Patentanwälte PartG mbB

(57) **Abstract**

The invention relates to an apparatus (100) for performing clock and/or data recovery for a data signal (dsi) of a first data rate, wherein said apparatus (100) comprises a controllable oscillator (110) for providing a clock signal (clk), and wherein said apparatus (100) further comprises a PLL, phased locked loop, unit (120) for controlling a phase and/or a frequency of said clock signal (clk) depending on said data signal (dsi), wherein both said controllable oscillator (110) and said PLL unit (120) are configured to operate at a frequency which corresponds to a second data rate, said second data rate being lower than said first data rate.

## Description

### Field of the invention

The present invention relates to an apparatus for performing clock and/or data recovery for a data signal of a first data rate. The present invention also relates to a method of operating such apparatus.

### Background

Conventional clock and data recovery (CDR) systems require numerous components to operate at a frequency which corresponds with the first data rate of the data signal that is to be subjected to clock and data recovery, which results in a comparatively large power consumption.

It is an object of the present invention to provide an improved apparatus and method of operating thereof which have a reduced power consumption.

### Summary

Regarding the aforementioned apparatus, according to the embodiments, this object is achieved by said apparatus comprising a controllable oscillator for providing a clock signal, and by said apparatus further comprising a PLL, phased locked loop, unit for controlling a phase and/or a frequency of said clock signal depending on said data signal, wherein both said controllable oscillator and said PLL unit are configured to operate at a frequency which corresponds to a second data rate, said second data rate being lower than said first data rate.

The principle according to the embodiments is based on the fact that in certain operational scenarios, it is not required to evaluate each bit of the data signal having the first data rate to successfully perform clock and/or data recovery. For example, in systems with time-multiplexed digital signals, the data signal may comprise m many time-multiplexed sub-signals such that e.g. only every m-th bit of the data signal actually belongs to one specific sub-signal. If only for this sub-signal a CDR process is to be performed, the principle according to the embodiments advantageously avoids evaluating all bits of the data signal, which would require processing the data signal with its full first data rate. The principle according to the embodiments takes advantage of the fact that it is sufficient to consider only every m-th bit, i.e. all bits belonging to the specific time-multiplexed sub-signal to perform a precise clock and/or data recovery for said sub-signal.

According to an embodiment, said PLL unit comprises a sampling unit which is configured to sample, with said second data rate, said data signal at at least two, preferably three, different phase positions, to obtain data signal samples. Thus, a reliable determination of the data signal may be accomplished and particularly, an efficient edge detection with respect to state changes of said data signal and its various TDM (time division multiplexing) sub-signals may be attained which facilitates selecting one of said plurality of TDM sub-signals.

According to a further embodiment, a distance between adjacent ones of said different phase positions for sampling by the sampling unit is smaller than a bit time of said data signal.

According to a further embodiment, said sampling unit comprises at least one flip flop device. For instance, one or more D-flip flops may be used, a data input of which receives the data signal to be sampled, and a clock input of which receives the clock signal (or a phase-shifted version of the clock signal) provided by said controllable oscillator. Other devices suitable for sampling such as a sample-and-hold circuit or the like may also be used. Advantageously, according to the principle of the embodiments, only the data input of the D-flip flop must be capable of handling the first data rate, because it receives the data signal. The clock input of the D-flip flop as well as any other components of the D-flip flop may be configured to operate at the lower second data rate according to the embodiments, which enables power savings and less costly devices.

According to a further embodiment, said PLL unit comprises a phase detector unit which is configured to control a phase and/or frequency of said clock signal provided by said controllable oscillator, depending on said data signal samples. For instance, the PLL unit may be configured to receive three signal samples of the data signals and to adjust a phase and/or frequency of the controllable oscillator depending on these signal samples, e.g. to maintain a predetermined phase relationship between the data signal (or one or more of its sub-signals) and the clock signal as provided by the controllable oscillator.

According to a further embodiment, said controllable oscillator comprises a primary output for providing said clock signal and at least two, preferably three, secondary outputs for providing phase-shifted output signals, whereby said phase-shifted output signals are phase-shifted copies of said clock signal provided at said primary output.

According to a further embodiment, said controllable oscillator comprises a ring oscillator having a plurality of oscillator stages connected in series to each other, and a selector unit, wherein said selector unit comprises M many inputs each of which is configured to be coupled to a respective output of a stage of said ring oscillator, and wherein said selector unit further comprises O many outputs, wherein O < M, wherein said selector unit is configured to connect a respective one of said inputs with a respective one of said outputs. This facilitates providing various phase-shifted copies of the clock signal of the controllable oscillator, which may e.g. be used for the PLL unit.

According to a further embodiment, said selector unit is configured to connect O many outputs of adjacent oscillator stages to the outputs of the selector unit, whereby comparatively small relative phase differences are obtained for the signals provided to the outputs of the selector unit.

According to a further embodiment, said data signal is a time-multiplexed (TDM) signal comprising a plurality of sub-signals which are time-multiplexed with each other, wherein said selector unit is configured to connect outputs of three specific subsequent oscillator stages to the outputs of the selector unit for selecting a specific sub-signal of the data signal. I.e., by selecting the output signals of three specific subsequent oscillator stages, a specific phase range in the data signal may be sampled if said output signals are used for clocking the sampling process. Thus, from a plurality of time-multiplexed sub-signals of the data signal, a respective one may be selected as reference for the clock and/or data recovery according to the embodiments.

A further solution to the object of the present invention is given by a method according to claim 10. Advantageous embodiments are presented by the dependent claims.

### Brief description of the figures

Further features, aspects and advantages of the present invention are given in the following detailed description with reference to the drawings in which:
Figure 1 depicts a schematic block diagram of a clock and/or data recovery apparatus according a first embodiment,
Figure 2 depicts a simplified flow chart of a method according to an embodiment,
Figure 3 depicts a schematic block diagram of a clock and/or data recovery apparatus according a further embodiment, and
Figure 4 depicts an operational scenario according to an embodiment.

### Description of the embodiments

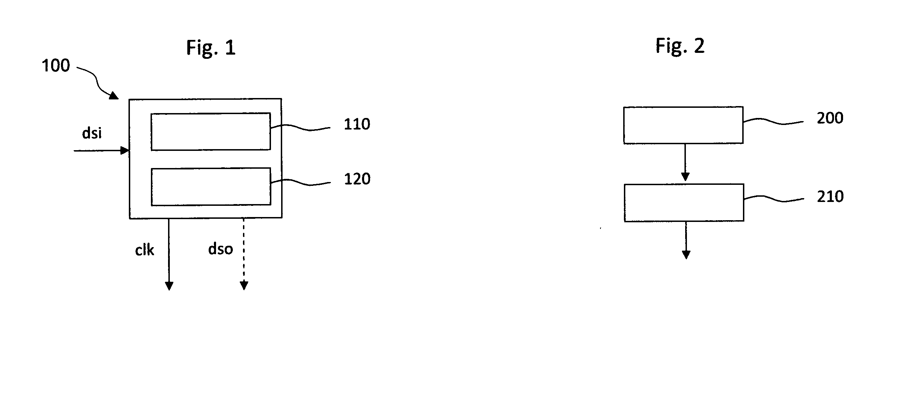

Figure 1 depicts a schematic block diagram of a clock and/or data recovery apparatus 100 according a first embodiment. The apparatus 100 is configured to receive at an input a digital data signal dsi which has a first data rate of e.g. about 10 Gbit/s. Such digital signals are e.g. used within passive optical networks (PONs) for downstream data transmissions from an optical line terminal (OLT), which may e.g. be located at a central office, to a plurality of optical network units (ONUs), said ONUs e.g. arranged at respective customer premises. More specifically, the apparatus 100 may preferably receive an electrical digital data signal with said first data rate. I.e., prior to supplying the usually optical downstream signal of the OLT to the apparatus 100, a conversion from the optical to the electrical domain is made by an O/E converter.

Thus, at its input, the apparatus 100 receives a digital data signal dsi with an exemplary data rate of about 10 Gbit/s. Other data rates, particularly also higher data rates, are also possible.

The apparatus 100 is configured to recover clock information and/or data information of the received digital data signal dsi. Clock and/or data recovery as such is known to the skilled man and thus not disclosed in further detail. The apparatus 100 may comprise a first output to output a recovered clock signal clk derived from said digital input signal dsi. Preferably, as an effect of the clock recovery, the recovered clock signal clk comprises a predetermined and particularly constant phase relationship to the digital data signal dsi or portions thereof. The recovered clock signal clk may e.g. be provided to subsequent processing stages which evaluate e.g. the data signal and its contents.

According to one embodiment, the apparatus 100 is configured to perform clock recovery only, i.e. to provide said recovered clock signal clk, but not to perform data recovery. This is indicated by the dashed arrow dso of Fig. 1.

According to another, preferred embodiment, the apparatus 100 is configured to perform both clock recovery and data recovery. Thus, in this embodiment, the apparatus 100 provides at a further output a recovered data signal dso in addition to the above explained recovered clock signal clk.

For performing clock and/or data recovery, the apparatus 100 comprises a controllable oscillator 110 and a PLL, phased locked loop, unit 120, both of which are indicated by respective blocks in the schematic view of Figure 1. The controllable oscillator 110 is configured to provide a clock signal which serves as a basis for the recovered clock signal clk to be output by the apparatus 100. The PLL unit 120 is configured to control a phase and/or a frequency of the clock signal of the controllable oscillator 110 depending on said data signal dsi. Thus, it is ensured that the recovered clock signal clk has a predetermined frequency and phase relationship with the received data signal dsi.

Conventional CDR systems require an oscillator and a phase comparator of a PLL stage to operate at a frequency which at least corresponds to the data rate of the digital signal dsi to be recovered (or is even higher by a predetermined factor). In the present example with the digital signal dsi having a first data rate of about 10 Gbit/s, the operating frequency of an oscillator and a phase comparator of a PLL stage of a conventional CDR system thus would be about at least 10 GHz, which requires costly hardware and a complex construction to handle the high frequencies or data rates, respectively. This complex and costly approach of the conventional CDR systems is even required if only a portion of the digital input signal dsi is to be evaluated by stages subsequent to the conventional CDR system. I.e., in the context of a PON with a downstream data rate of 10 Gbit/s, ONU receiver hardware must comprise a CDR many components of which are operating at about at least 10 GHz or 10 Gbit/s, even if the ONU is only to evaluate a portion of the downstream signal, said portion amounting to e.g. one eighth of the whole downstream signal.

To address this problem of conventional CDR, advantageously, according to the embodiments, both said controllable oscillator 110 (Fig. 1) and said PLL unit 120 are configured to operate at a frequency which corresponds to a second data rate, said second data rate being lower than said first data rate. This firstly reduces the costs for the respective components because they are only required to handle said second, i.e. lower, data rate, or signal frequencies, respectively. Furthermore, the whole hardware concept is simplified according to the embodiments, since a layout of components also has to take into consideration only the reduced maximum frequency associated with the second data rate.

As an example, if the digital data signal dsi comprises a first data rate of about 10 Gbit/s, the second data rate according to the embodiments is e.g. chosen such that it corresponds to an effective data rate of a portion of the digital data signal dsi which is indeed to be evaluated by components subsequent to the apparatus 100. In many practical scenarios, the portion of the digital data signal dsi which is indeed to be evaluated by components subsequent to the apparatus 100 is only about 20 percent or even less.

For example, in systems with time-multiplexed digital signals dsi, the data signal dsi may comprise m many time-multiplexed sub-signals such that e.g. only every m-th bit of the data signal dsi actually belongs to one specific sub-signal (= TDM channel). Thus, in effect, the corresponding effective data rate of the specific sub-signal is about (1/m)-th of the full first data rate. Hence, if only for this sub-signal a CDR process is to be performed by the apparatus 100, the principle according to the embodiments advantageously avoids evaluating all bits of the data signal dsi, which would disadvantageously require processing the data signal with its full first data rate. Note that conventional CDR systems also process the data signal dsi with its full first data rate, regardless of which portion or fraction of the data signal dsi is indeed required to be evaluated after the CDR process.

In other words, the principle according to the embodiments relies on the insight that it is sufficient to consider only every m-th bit, i.e. all bits belonging to a specific time-multiplexed sub-signal of the data signal dsi to perform a precise clock and/or data recovery for said sub-signal, which advantageously avoids the requirement of processing all bits of the data signal dsi at the full first data rate.

For example, if the 10 Gbit/s data signal dsi is a time division multiplexing (TDM) signal that comprises m = 8 time multiplexed sub-signals such that every eighth bit of the data signal dsi belongs to a specific one of said sub-signals, according to the embodiments, it is sufficient for proper clock and/or data recovery that the components of the apparatus 100, particularly the controllable oscillator 110 and the PLL unit 120, are configured to operate at a second data rate which corresponds to the effective data rate of the specific sub-signal to be evaluated. I.e., in this example, the second data rate may be chosen to be about 1.25 Gbit/s instead of 10 Gbit/s.

In view of the fact that PONs supplying numerous customers with one digital TDM data signal dsi, the effective customer data rate for downstream signals may be assumed to be in a range of about 10 Mbit/s up to some 100 Mbit/s or 1 Gbit/s. Thus, in such scenarios, when employing the apparatus 100 according to the embodiments, its components may advantageously be operated at said correspondingly low second (i.e., customer) data rates of about 10 Mbit/s up to some 100 Mbit/s or 1 Gbit/s.

Thus, by applying the inventive principle, a less complex and costly CDR is enabled which is particularly useful for PON systems since the ONUs at the customer's sites should not be too costly.

Generally, the second data rate according to the embodiments may be chosen depending on the effective data rate of the signal to be evaluated after the CDR process. Particularly, it is not required to be equal to a usually much higher data rate of the received data signal dsi. I.e., the second data rate scales directly with the effective data rate of the signal to be evaluated after the CDR process, so that there are only very few requirements for the apparatus 100 to handle higher data rates than said second data rate. Of course, the input of the apparatus 100 which receives said digital signal dsi at a first data rate of e.g. 10Gbit/s or more must be capable of handling the first data rate. However, the further components, especially the oscillator 110 and the PLL unit 120, are only required to operate at the lower second data rate.

Figure 2 depicts a simplified flow chart of an embodiment. In a first step 200, the apparatus 100 receives a digital data signal dsi at a first data rate of e.g. 10 Gbit/s. In a further step 210 the apparatus 100 performs a clock and/or data recovery, wherein both said controllable oscillator 110 (Fig. 1) and said PLL unit 120 are configured to operate at a frequency which corresponds to a second data rate that is lower than said first data rate. Obviously, steps 200, 210 may be performed in a continuous manner wherein steps 200, 210 may also be performed simultaneously.

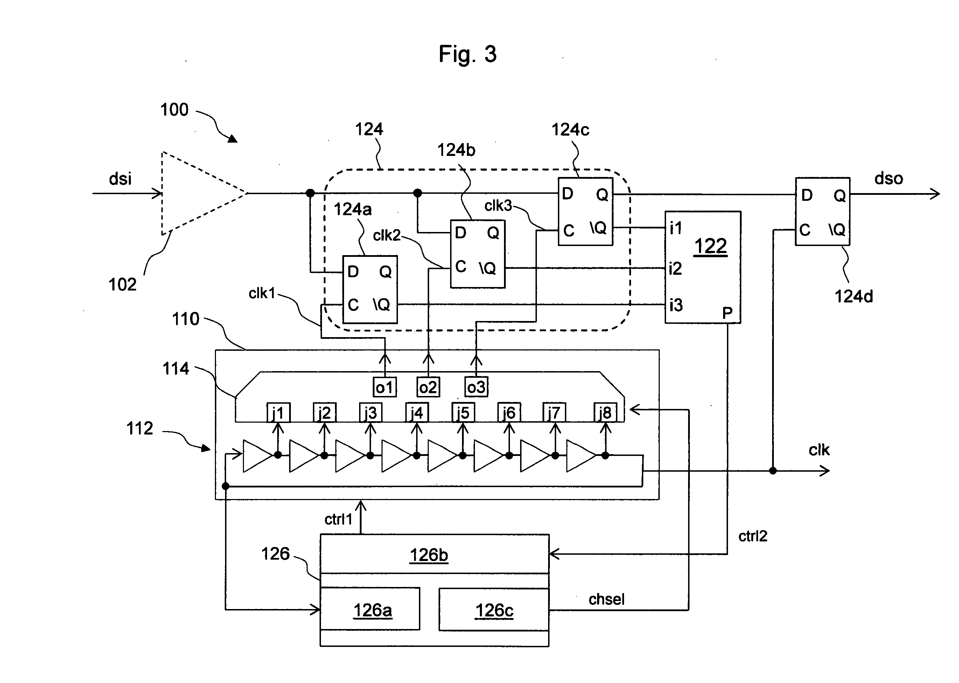

Figure 3 depicts a schematic block diagram of a clock and/or data recovery apparatus 100 according a further embodiment. At an input (not shown), the apparatus 100 receives a digital input signal dsi, which may be amplified by an optional amplifier 102 prior to clock and/or data recovery.

The apparatus 100 comprises a controllable oscillator 110. "Controllable" in the context of the oscillator 110 means that a frequency of an output signal clk of the oscillator 110 and/or a phase of said output signal clk can be controlled. The mechanisms for controlling said frequency and/or phase are explained further below.

According to one embodiment, the controllable oscillator 110 comprises a ring oscillator 112 having a plurality of oscillator stages connected in series to each other, wherein an output of the last stage is fed back to an input of the first stage. In the present embodiment, the output of the last stage of the ring oscillator 112 at the same time represents an overall output of the controllable oscillator 112 providing a clock signal clk.

Presently, there are eight oscillator stages each of which may e.g. comprise an inverter which is not separately designated in Fig. 3 for the sake of clarity.

According to a further embodiment, the controllable oscillator 112 further comprises a selector unit 114, wherein said selector unit 114 comprises M many (presently M = 8) inputs j1, .., j8 each of which is configured to be coupled to a respective output of a stage of said ring oscillator 112. Since a respective output signal of a specific stage of said ring oscillator 112 represents a phase-shifted instance of the output signal clk of the oscillator, wherein the specific phase shift corresponds to the position of the specific stage within said chain of stages, the selector unit 114 may receive various phase-shifted copies of the clock signal clk output by the oscillator 110.

Said selector unit 114 further comprises O many (presently O = 3) outputs o1, o2, o3. According to a particularly preferred embodiment, O = 3, and O < M.

Said selector unit 114 is configured to connect a respective one of said inputs j1, .., j8 with a respective one of said outputs o1, o2, o3. Thus, to any of the three outputs o1, o2, o3, a phase-shifted instance of the clock signal clk having a specific phase shift with respect to the clock signal clk may be forwarded from a respective input of the selector unit 114.

According to a further embodiment, said selector unit 114 is configured to connect O many outputs of adjacent oscillator stages to the outputs o1, o2, o3 of the selector unit 114. I.e., in one operational state, the selector unit 114 may be controlled to connect input j1 to output o1, and to connect input j2 to output o2, and to connect input j3 to output o3, whereas in another operational state, the selector unit 114 may be controlled to connect input j4 to output o1, and to connect input j5 to output o2, and to connect input j6 to output o3, and the like. This has the effect that the selector unit 114 outputs at its outputs o1, o2, o3 clock signals with the respective phase shifts with reference to the output clock signal clk of the oscillator 110.

However, according to a further embodiment, to attain larger relative phase shifts between the output signals output at the three outputs o1, o2, o3, the selector unit 114 may also be controlled to connect e.g. input j1 to output o1, and to connect input j3 to output o2, and to connect input j5 to output o3, whereby the phase differences between the selector unit's output signals are doubled with respect to an embodiment where three adjacent stages' output signals are forwarded to the outputs o1, o2, o3.

Generally, any input j1, .., j8 may be connected to any output o1, o2, o3 of the selector unit 114 thus offering many combinations of phase differences between the output signals clk1, clk2, clk3 available at the outputs o1, o2, o3 of the selector unit 114.

According to further embodiments, the selector unit 114 may also comprise any other number of inputs and/or outputs.

The selector unit 114 is configured to receive a control signal chsel which may be used to define which connecting pattern between inputs j1, .., j8 and outputs o1, o2, o3 to apply.

As is well known, the basic oscillating frequency of the ring oscillator 112 may be set by choosing the number of stages. However, for dynamically, i.e. during operation, changing the frequency of the output clock signal clk, one or more control signals ctrl1 may be applied to the oscillator 110 which e.g. affect an operating voltage of the inverter stages and/or control a controllable capacity of capacity diodes (not shown) included in the ring oscillator 112 and the like. Thus, by using the control signal ctlr1, the frequency and also the phase of the output clock signal clk may be tuned to a desired value.

To enable a control of the controllable oscillator 110 such that its output signal clk attains a predetermined phase relationship with the input data signal dsi or portions thereof, the control signal ctlr1 is provided to the controllable oscillator 110 by a PLL control unit 126 which is part of the PLL unit 120 a structure and operation of which is explained below in further detail.

According to an embodiment, the PLL unit 120 comprises a phase detector unit 122, a sampling unit 124 and the PLL control unit 126. I.e., the PLL control unit 126 is part of the PLL unit 120.

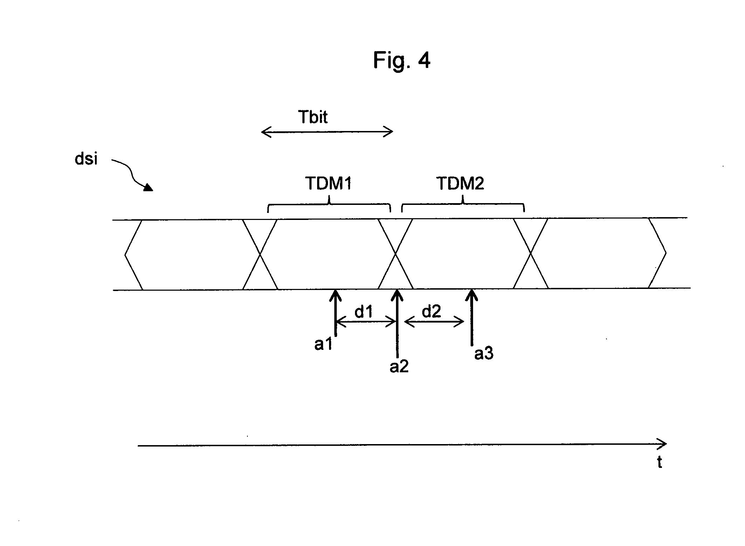

The sampling unit 124 is configured to sample, with said second data rate according to the embodiments, said data signal dsi at at least two, preferably three, different phase positions to obtain data signal samples. Figure 4 depicts a respective operational scenario, wherein an eye-diagram type depiction of the data signal dsi is provided together with a relative time coordinate. A bit time Tbit corresponding to a duration of one bit of the data signal with its first data rate of e.g. 10 Gbit/s is indicated by a respective double arrow in Figure 4. As mentioned above, the digital signal dsi is a TDM signal comprising e.g. eight TDM sub-signals. Correspondingly, the range TDM1 of Figure 4 denotes a first TDM sub-signal TDM1, which may also be referred to as a first data channel. The adjacent range TDM2 of Figure 4 denotes a second TDM sub-signal TDM2, which may also be referred to as a second data channel.

As stated above, the sampling unit 124 (Fig. 3) is configured to sample, with said second data rate according to the embodiments, said data signal dsi at at least two, preferably three, different phase positions a1, a2, a3 (Fig. 4) to obtain data signal samples. The respective phase positions may e.g. be controlled by the phase-shifted clock signals clk1, clk2, clk3, which are phase-shifted copies of the output clock signal clk and which are output by the selector unit 114 under respective control by means of the control signal chsel. Evidently, the phase positions a1, a2, a3 for sampling may be altered by changing the connecting pattern between inputs and outputs of the selector unit 114.

According to a preferred embodiment, a distance d1, d2 between adjacent ones a1, a2 and a2, a3 of said different phase positions a1, a2, a3 is smaller than a bit time Tbit of said data signal dsi. Thus, it is ensured that by proper control of the oscillator 110 a first phase position a1 may lie within a first data channel TDM1 and a third phase position a3 may lie within an adjacent second data channel TDM2, whereas the intermediate second phase position a2 lies within an edge region between said adjacent data channels TDM1, TDM2. According to a further embodiment, the distances d1, d2 equal about Tbit/2, i.e. d1+d2 is about Tbit.

This advantageously enables to provide the phase detector unit 122 with corresponding input signal samples which enables the phase detector unit 122 to determine a phase and/or frequency control signal ctrl2 that triggers the PLL control unit 126 to adjust a phase and/or frequency of the clock signal clk.

According to a preferred embodiment, said sampling unit 124 comprises at least one flip flop device 124a, 124b, 124c. Presently, the sampling unit 124 comprises three D-flip flops 124a, 124b, 124c.

As depicted by Fig. 4, a data input D of the first flip-flop 124a receives the (optionally amplified) data signal dsi to be sampled, and a clock input C of the first flip-flop 124a receives a first phase-shifted clock signal clk1, which is a phase-shifted copy of the clock signal clk. I.e., the first phase-shifted clock signal clk1 comprises the same frequency as the clock signal clk, but a non-vanishing phase shift with respect to said clock signal clk, said non-vanishing phase shift depending on which one of said inputs j1 to j8 of the selector unit 114 is connected to its first output o1. An inverting output \Q of said first flip flop 124a is connected to a third input i3 of the phase detector unit 122. Presently, the noninverting output Q of the first flip flop 124a is unused.

As also depicted by Fig. 4, a data input D of the second flip-flop 124b receives the (optionally amplified) data signal dsi to be sampled, and a clock input C of the second flip-flop 124b receives a second phase-shifted clock signal clk2, which is a phase-shifted copy of the clock signal clk. I.e., the second phase-shifted clock signal clk2 comprises the same frequency as the clock signal clk, but non-vanishing phase shifts with respect to said clock signals clk, clk1, said non-vanishing phase shifts depending on which one of said inputs j1 to j8 of the selector unit 114 is connected to its second output o2 that provides said second phase-shifted clock signal clk2. An inverting output \Q of second flip flop 124b is connected to a second input i2 of the phase detector unit 122. Presently, the noninverting output Q of the second flip flop 124b is unused.

As also depicted by Fig. 4, a data input D of the third flip-flop 124c receives the (optionally amplified) data signal dsi to be sampled, and a clock input C of the third flip-flop 124c receives a third phase-shifted clock signal clk3, which is a phase-shifted copy of the clock signal clk. I.e., the third phase-shifted clock signal clk3 comprises the same frequency as the clock signal clk, but non-vanishing phase shifts with respect to said clock signals clk, clk1, clk2, said non-vanishing phase shifts depending on which one of said inputs j1 to j8 of the selector unit 114 is connected to its third output o3 that provides said third phase-shifted clock signal clk3. An inverting output \Q of third flip flop 124c is connected to a first input i1 of the phase detector unit 122.

The noninverting output Q of the third flip flop 124c is connected to a data input D of a further flip flop 124d and serves as such for providing the recovered data signal dso, which is obtained at an noninverting output Q of the further flip flop 124d. The provisioning of the further flip flop 124d as such implements a re-sampling of the data signal output by noninverting output Q of the third flip flop 124c at the second data rate / frequency of the clock signal clk which helps to avoid glitches of the output signal dso.

As explained above, by appropriately configuring a switch pattern of the selector unit 114, the phase-shifted clock signals clk1, clk2, clk3, which define the sampling positions a1, a2, a3 as explained with reference to Fig. 4, may be selected such that e.g. the first flip flop 124a samples the data signal dsi at the first phase position a1 (Fig. 4), that e.g. the second flip flop 124b samples the data signal dsi at the second phase position a2 (Fig. 4), and that e.g. the third flip flop 124c samples the data signal dsi at the third phase position a3 (Fig. 4).

Thus, respective sampled values of the data signal dsi at the three phase positions a1, a2, a3 are provided by the respective flip flops 124a, 124b, 124c to the inputs i1, i2, i3 of the phase comparator unit 122. On this basis, the phase detector unit 122 may determine, and output at port P, a phase and/or frequency control signal ctrl2 that triggers the PLL control unit 126 to adjust a phase and/or frequency of the clock signal clk, e.g. with the aim to maintain the second phase position a2 in the edge range between two adjacent TDM data channels TDM1, TDM2. This has the effect that the surrounding phase positions a1, a3 reliably are centered within the bit times of the respective data channels TDM1, TDM2 so that the surrounding phase positions a1, a3 may operate as a reference for sampling either data channel TDM1, TDM2.

Presently, as third flip flop 124c samples the data signal dsi at the third phase position a3, cf. above, the output signal Q of the third flip flop 124c is a sampled signal that is obtained by sampling the original data signal dsi with the clock frequency of clock signal clk3. In effect, thus, the third flip flop 124c samples each subsequent bit of the TDM channel TDM2 of the data signal dsi, whereby data recovery of the TDM channel TDM2 is effected, the recovered data signal being output by output Q of the third flip flop 124c and being sampled by the further flip flop 124c, this sampling again clocked by the clock signal clk.

Thus, altogether, the apparatus 100 according to the embodiments enables to perform clock and/or data recovery based on an input signal dsi, which has a high first bit rate (e.g., 10 Gbit/s), while enabling all involved components 110, 120 to operate at a lower second data rate (e.g., 1.25 Gbit/s). The recovered data signal dso is obtained at an output of the flip flop 124c or 124d, respectively, and the recovered clock signal is represented by the output signal clk of the oscillator 110.

Particularly, the oscillator 110 and the PLL unit 120 are only required to operate at the lower second data rate or corresponding frequency, respectively.

With the embodiment according to Fig. 3, the data inputs D of the sampling flip flops 124a, 124b, 124c are the only components of the whole apparatus 100 that are required to handle a signal dsi having the first data rate. Even the remaining (internal) components of these flip flops 124a, 124b, 124c are only required to operate at the lower second data rate.

According to an embodiment, the PLL control unit 126 is configured to receive the output signal clk of the oscillator 110. A frequency supervision unit 126a may be provided that supervises a current frequency of the clock signal clk. Depending on this supervision and/or e.g. on the control signal ctrl2 from the phase detector unit 122, the PLL control unit 126 may tune, i.e. alter, the phase and/or frequency of the clock signal clk, i.e. by means of the control signal ctrl1 to the oscillator 110.

The PLL control unit 126 may comprise a PLL filter unit 126b which e.g. receives the control signal ctrl2 from the phase detector unit 122 and which generates the control signal ctrl1 to the oscillator 110.

According to a further embodiment, the PLL control unit 126 may also comprise a channel selection unit 126c which is configured to provide a control signal chsel for the selector unit 114 which may be used to define which connecting pattern between inputs j1, .., j8 and outputs o1, o2, o3 of the selector unit 114 to apply thus influencing the phase of the phase-shifted clock signals clk1, clk2, clk3 that are used for clocking the sampling process of the sampling unit 124. Also, by means of the control signal chsel for the selector unit 114, phase differences between said phase-shifted clock signals clk1, clk2, clk3 may be controlled.

Advantageously, the channel selection unit 126c may also control the selector unit 114 so as to change from a first set of phase-shifted clock signals clk1, clk2, clk3 to a second set of phase-shifted clock signals clk1, clk2, clk3, the second set being characterized by different phase positions with respect to the clock signal. This is equivalent to shifting the three phase positions a1, a2, a3 illustrated by Fig. 4 along the relative time coordinate t. Thus, e.g., the sampling unit 124 and its sampling phase positions a1, a2, a3 may be moved from a first TDM channel TDM1 to another TDM channel TDM2, and the like, thus effecting a switching of the clock and/or data recovery operation from a first TDM channel TDM1 to another TDM channel TDM2 of the data signal dsi. Of course, this is also possible for more than two TDM channels. Thus, by controlling the selector unit 114 with the control signal chsel, the apparatus 100 may easily be tuned to select one specific of a plurality of TDM channels of said data signal dsi for applying clock and/or data recovery.

Advantageously, said tuning between different TDM channels by means of the aforementioned reconfiguration of the selector unit 114 is fast enough so that the PLL unit 120 does not lose synchronization due to said tuning. Thus, the apparatus 100 may efficiently select one of a plurality of TDM channels for clock and/or data recovery without the need for a complete resynchronization with a new TDM channel once it has been switched to said new channel. With the specific configuration depicted by Fig. 3, at least eight different positions a3 for sampling the data signal portion to be recovered may be provided.

According to a further embodiment, instead of one or more of said flip-flops 124a, .., 124d, other devices suitable for sampling such as sample-and-hold circuits or the like may also be used.

Advantageously, according to the principle of the embodiments, only the data input D of a D-flip flop 124a, 124b, 124c must be capable of handling the first data rate, because it receives the data signal dsi. The clock input C of the D-flip flops as well as any other components of the D-flip flop may be configured to operate at the lower second data rate according to the embodiments, which enables power savings and less costly devices.

According to a further embodiment, instead of a ring oscillator 112, another type of oscillator may also be used for generating the clock signal clk at a frequency corresponding to the second data rate. For example, an array of delay units (not shown) may be used to derive several phase-shifted clock signals clk1, clk2, clk3 from said clock signal in order to provide the sampling unit 124 with respective clock signals for sampling.

According to a further embodiment, it is also possible to employ only two phase positions (i.e., positions a1, a3 of Fig. 4) for sampling. In this case, the phase detector 122 has to be configured to operate correspondingly, i.e. adjusting the phase of the clock signal so as to keep the phase positions a1, a3 sufficiently aligned within about the middle of the bit times of adjacent TDM channels TDM1, TDM2. Using more than three phase positions a1, a2, a3 for sampling and performing phase detection is also possible according to a further embodiment.

The principle according to the embodiments is based on the basic idea to process only the required data (i.e. one out of many TDM channels of the data signal dsi) and not the full bit rate data signal dsi. This idea is implemented in that way, that not every bit is sampled (with the need for full data rate sampling at the first data rate) as in a conventional CDR, but only the further processed bits, which enables to drastically reduce power consumption of the apparatus 100.

According to a further embodiment, the apparatus 100 may comprise a calculating unit (not shown) such as a microprocessor or DSP or an ASIC or FPGA for implementing one or more of the above explained control procedures or for controlling one or more components of the apparatus 100 or the operation of the apparatus 100 in general.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the FIGs., including any functional blocks labelled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Apparatus (100) for performing clock and/or data recovery for a data signal (dsi) of a first data rate, wherein said apparatus (100) comprises a controllable oscillator (110) for providing a clock signal (clk), and wherein said apparatus (100) further comprises a PLL, phased locked loop, unit (120) for controlling a phase and/or a frequency of said clock signal (clk) depending on said data signal (dsi), wherein both said controllable oscillator (110) and said PLL unit (120) are configured to operate at a frequency which corresponds to a second data rate, said second data rate being lower than said first data rate.

2. Apparatus (100) according to claim 1, wherein said PLL unit (120) comprises a sampling unit (124) which is configured to sample, with said second data rate, said data signal (dsi) at at least two, preferably three, different phase positions (a1, a2, a3), to obtain data signal samples.

3. Apparatus (100) according to claim 2, wherein a distance (d1, d2) between adjacent ones of said different phase positions (a1, a2, a3) is smaller than a bit time (Tbit) of said data signal (dsi).

4. Apparatus (100) according to one of the claims 2 to 3, wherein said sampling unit (124) comprises at least one flip flop device (124a, 124b, 124c).

5. Apparatus (100) according to one of the claims 2 to 4, wherein said PLL unit (120) comprises a phase detector unit (122) which is configured to control a phase and/or frequency of said clock signal (clk) provided by said controllable oscillator (110), depending on said data signal samples.

6. Apparatus (100) according to one of the preceding claims, wherein said controllable oscillator (110) comprises a primary output for providing said clock signal (clk) and at least two, preferably three, secondary outputs for providing phase-shifted output signals (clk1, clk2, clk3).

7. Apparatus (100) according to one of the preceding claims, wherein said controllable oscillator (110) comprises a ring oscillator (112) having a plurality of oscillator stages connected in series to each other, and a selector unit (114), wherein said selector unit (114) comprises M many inputs (j1, .., j8) each of which is configured to be coupled to a respective output of a stage of said ring oscillator (112), and wherein said selector unit (114) further comprises O many outputs (o1, o2, o3), wherein O < M, wherein said selector unit (114) is configured to connect a respective one of said inputs (j1, .., j8) with a respective one of said outputs (o1, o2, o3).

8. Apparatus according to claim 7, wherein said selector unit (114) is configured to connect O many outputs of adjacent oscillator stages to the outputs (o1, o2, o3) of the selector unit (114).

9. Apparatus according to claim 7 or 8, wherein said data signal (dsi) is a time-multiplexed signal comprising a plurality of sub-signals which are time-multiplexed with each other, wherein said selector unit (114) is configured to connect outputs of three specific subsequent oscillator stages to the outputs (o1, o2, o3) of the selector unit (114) for selecting a specific sub-signal of the data signal (dsi).

10. Method of operating an apparatus (100) for performing clock and/or data recovery, wherein said apparatus (100) comprises a controllable oscillator (110) for providing a clock signal (clk), and wherein said apparatus (100) further comprises a PLL, phased locked loop, unit (120) for controlling a phase and/or a frequency of said clock signal (clk) depending on said data signal (dsi), wherein both said controllable oscillator (110) and said PLL unit (120) operate at a frequency which corresponds to a second data rate, said second data rate being lower than said first data rate.

11. Method according to claim 10, wherein said PLL unit (120) comprises a sampling unit (124) which samples, with said second data rate, said data signal (dsi) at at least two, preferably three, different phase positions (a1, a2, a3), to obtain data signal samples.

12. Method according to claim 11, wherein said controllable oscillator (110) provides at a primary output said clock signal (clk) and at at least two, preferably three, secondary outputs phase-shifted output signals (clk1, clk2, clk3).

13. Method according to one of the claims 10 to 12, wherein said controllable oscillator (110) comprises a ring oscillator (112) having a plurality of oscillator stages connected in series to each other, and a selector unit (114), wherein said selector unit (114) comprises M many inputs (j1, .., j8) each of which is configured to be coupled to a respective output of a stage of said ring oscillator (112), and wherein said selector unit (114) further comprises O many outputs (o1, o2, o3), wherein O < M, wherein said selector unit (114) connects a respective one of said inputs (j1, .., j8) with a respective one of said outputs (o1, o2, o3).
